# EUROPÄISCHE PATENTSCHRIFT

(11) **EP 3 830 907 B1**
(45) Veröffentlichungstag und Bekanntmachung des Hinweises auf die Patenterteilung: **19.04.2023**
(21) Anmeldenummer: 19746079.3
(22) Anmeldetag: 26.07.2019
(51) Int. Cl.: H01R 12/72, H01R 24/50, H01R 13/6477, H01R 13/659, H01R 101/00

(54) **KANTENRAND-STECKVERBINDER SOWIE LEITERPLATTENANORDNUNG**
EDGE CONNECTOR AND PRINTED CIRCUIT BOARD ASSEMBLY
CONNECTEUR DE BORD ENFICHABLE ET ENSEMBLE DE CARTE DE CIRCUIT IMPRIMÉ

(30) Priorität: 27.07.2018 DE 102018118224; 27.07.2018 DE 202018106554 U
(43) Veröffentlichungstag der Anmeldung: 09.06.2021
(73) Patentinhaber: IMS Connector Systems GmbH, 79843 Löffingen (DE)
(72) Erfinder: MÜLLINGER-BAUSCH, Christoph, 79822 Titisee-Neustadt (DE); BAUMGÄRTNER, Roland, 79848 Bonndorf-Wellendingen (DE); REGENBRECHT, Michael, 42929 Wermelskirchen (DE)
(74) Vertreter: Westphal, Mussgnug & Partner Patentanwälte mbB
(86) Internationale Anmeldenummer: PCT/EP2019/070235
(87) Internationale Veröffentlichungsnummer: WO 2020/021091

(56) Entgegenhaltungen:
- WO-A1-96/17410
- DE-T2- 69 103 652
- DE-T2- 69 205 131
- DE-T2- 69 302 496
- DE-T2- 69 901 084
- US-A1- 2004 121 625
- US-A1- 2005 221 631
- US-A1- 2011 039 423

## Beschreibung

Die vorliegende Erfindung betrifft einen Kantenrand-Steckverbinder für eine Leiterplatte mit den Merkmalen des Patentanspruchs 1 sowie eine Leiterplattenanordnung mit den Merkmalen des Anspruchs 10.

Kantenrand-Steckverbinder sind in unterschiedlichen Ausgestaltungen aus dem Stand der Technik bekannt und werden auch unter der englischen Bezeichnung "Edge Mount Connector" angeboten. Kantenrand-Steckverbinder werden typischerweise im Bereich einer Seitenkante einer Leiterplatte angeordnet, um ein elektrisches Signal über den Kantenrand-Steckverbinder von einem entfernt angeordneten Sensor oder einer Antenne mit einer in der Leiterplatte elektrisch isoliert angeordneten Leiterbahn elektrisch zu verbinden. Die Signale sind oftmals hochfrequente (HF) Signale. Um eine störungsfreie Übertragung der Signale sicherzustellen, werden die Signale mittels Koaxialkabel übertragen, die gegen elektrische- und/oder elektromagnetische Felder durch einen Außenleiter, der den signalführenden Leiter umgibt, abgeschirmt sind. Dementsprechend sind die aus dem Stand der Technik bekannten Steckverbinder typischerweise als koaxiale Steckverbinder ausgebildet, deren Außengehäuse einen Außenleiter bilden und eine Seitenkante einerseits zur Befestigung die Leiterplatte umgreifen und andererseits mit einer weiteren Leiterbahn elektrisch verbunden sind, um eine Erdung zum Ausleiten der elektrischen und/oder elektromagnetischen Felder zu ermöglichen.

Weiteren Stand der Technik bilden die Druckschriften DE 699 01 084 T2, US 2011 039 423 A1, DE 692 05 131 T2, DE 691 03 652 T2, DE 693 02 496 T2, US 2004 121 625 A1, WO 96 17410 A1 und US 2005 221 631 A1.

Als nachteilig an diesem Stand der Technik hat sich erwiesen, dass die aus dem Stand der Technik bekannten Kantenrand-Steckverbinder lediglich das simultane Verbinden eines Leiters ermöglichen. Auch hat es sich als nachteilig erwiesen, dass durch das direkte Kontaktieren der Leiterbahnen mit dem Steckverbinder ein mehrmaliges Lösen und Wiederherstellen der Steckverbindung zu einer Zerstörung der Leiterbahnen auf der Leiterplatte führt, die Montage der derzeit bekannten Kantenrand-Steckverbinder aufwendig ist und nur bedingt in einem SMT-Verfahren an der Leiterplatte angebracht werden kann.

Hier setzt die vorliegende Erfindung an.

Es ist die Aufgabe der vorliegenden Erfindung, einen Kantenrand-Steckverbinder für eine Leiterplatte zur Verfügung zu stellen, der das simultane Verbinden mindestens eines Leiters, vorzugsweise einer Mehrzahl von Leitern ermöglicht, und dabei eine möglichst geringe Bauhöhe aufweist, wodurch der für eine Leiterplattenanordnung verfügbare Bauraum möglichst effizient ausgenutzt wird. Weiterhin soll der Kantenrand-Steckverbinder die Entstehung von passiven Intermodulationen aufs Geringste reduzieren, und eine bestmögliche Schirmung der Leiter gegen elektrische und/oder elektromagnetische Felder gewährleisten. Darüber hinaus soll der Kantenrand-Steckverbinder ein SMD-fähiges Bauteil sein, das eine kostengünstige und voll automatisierte Herstellung einer Leiterplattenanordnung mit herkömmlichen Fertigungsverfahren ermöglicht.

Diese Aufgaben werden durch einen Kantenrand-Steckverbinder mit den Merkmalen des Anspruchs 1 sowie mit einer Leiterplattenanordnung mit den Merkmalen des Anspruchs 10 gelöst.

Die Unteransprüche geben weitere vorteilhafte Ausgestaltungen des Kantenrand-Steckverbinders sowie der Leiterplattenanordnung an.

Der erfindungsgemäße Kantenrand-Steckverbinder für eine Leiterplatte umfasst wenigstens ein zweiteiliges Gehäuse mit einem ersten Gehäuseteil und einem zweiten Gehäuseteil, wobei das erste Gehäuseteil eine Ausnehmung aufweist, in der mindestens ein Leiter angeordnet ist.

Der mindestens eine Leiter in der Ausnehmung ist erfindungsgemäß zum Übertragen eines hochfrequenten elektrischen Signals, insbesondere einer Antenne, ausgelegt. Darüber hinaus umfasst der jeweilige mindestens eine Leiter einen ersten Schenkel mit einem ersten Ende und einen zweiten Schenkel mit einem zweiten Ende, wobei das erste Ende eingerichtet ist, eine elektrische Verbindung mit einer Leiterbahn der Leiterplatte herzustellen, und dass zweite Ende eingerichtet ist, eine elektrische Verbindung mit einem entsprechenden elektrischen Kontakt eines Gegensteckverbinders herzustellen. Das Gehäuse umfasst weiterhin einen ersten Bereich in einer ersten Ebene, indem das jeweilige erste Ende des mindestens einen Leiters in einer Montagerichtung aus dem Gehäuse zur Verbindung mit einer Leiterbahn der Leiterplatte ragt. In dem ersten Bereich ist eine Unterseite des Gehäuses demnach eingerichtet, auf einer Oberseite der Leiterplatte in der ersten Ebene aufzuliegen, wobei aus der ersten Ebene in die Montagerichtung das jeweilige erste Ende des jeweiligen Leiters herausragt, welches beispielsweise durch eine Durchbohrung in der Leiterplatte zur Verbindung mit der Leiterbahn auf einer Unterseite der Leiterplatte absteht. Darüber hinaus umfasst das Gehäuse einen zweiten Bereich, der in mindestens einer zweiten Ebene ausgebildet ist, welche in der Montagerichtung parallel und beabstandet zu der ersten Ebene angeordnet ist. In dem zweiten Bereich ist demnach eine Unterseite des Gehäuses ausgebildet, in eine in die Leiterplatte eingearbeitete Aussparung hinein zu ragen oder hindurchzutreten. Dadurch wird eine Reduzierung der Gesamthöhe der Leiterplattenanordnung mit einem erfindungsgemä-ßen Kantenrand-Steckverbinder ermöglicht. Der zweite Bereich des Gehäuses durchdringt demnach die Aussparung der Leiterplatte. Weiterhin ist es erfindungsgemäß vorgesehen, dass der zweite Schenkel in einem Winkel, bevorzugt um 90°, zu dem ersten Schenkel angeordnet ist und in eine Gegensteckerausnehmung in einer Steckrichtung in das zweite Gehäuseteil ragt. Demnach steht das zweite Ende an dem zweiten Schenkel des mindestens einen Leiters frei in der Steckerausnehmung und kann durch die entsprechenden Kontakte des Gegensteckverbinders eine elektrische Verbindung mit diesem herstellen.

Erfindungsgemäß ist vorgesehen, dass das erste Gehäuseteil mit dem zweiten Gehäuseteil fest verbunden ist, und dass das zweite Gehäuseteil aus einem nicht-elektrisch leitfähigen Werkstoff, insbesondere einem Kunststoff hergestellt ist. Durch eine derartige Ausgestaltung des zweiten Gehäuseteils werden Metall-zu-Metall Kontakte innerhalb des Gehäuses des erfindungsgemäßen Kantenrand-Steckverbinders vermieden, wodurch die Entstehung von passiven Intermodulationen (PMI) reduziert ist. Darüber hinaus können beispielsweise die beiden Gehäuseteile in einem Spritzgussverfahren hergestellt werden, wobei besonders bevorzugt das erste Gehäuseteil aus einem elektrisch leitfähigen Werkstoff hergestellt ist, und das zweite Gehäuseteil aus einem Kunststoff, insbesondere einem SMT-fähigen Werkstoff, der den bei dem Verlöten der elektrischen Kontakte vorherrschenden Temperaturen standhält.

Auch ist es vorteilhaft, wenn der Kantenrand-Steckverbinder als Kantenrand-Mehrfach-Steckverbinder ausgebildet ist und mindestens zwei Leiter aufweist, die beabstandet zueinander angeordnet sind und deren jeweiliger zweiter Schenkel in die Gegensteckerausnehmung des zweiten Gehäuseteils hineinragen. Bevorzugt sind die mindestens zwei Leiter in eine Richtung senkrecht zur Steckrichtung zueinander beabstandet.

Eine weitere vorteilhafte Ausgestaltung der vorliegenden Erfindung sieht vor, dass die mindestens zwei Leiter des Kantenrand-Mehrfach-Steckverbinders in mindestens zwei Reihen zueinander parallel angeordnet sind, wobei weiter bevorzugt die jeweilige Reihe parallel zu der ersten Ebene angeordnet ist bzw. parallel zu der Oberfläche der Leiterplatte angeordnet ist.

Das erste Gehäuseteil und das zweite Gehäuseteil bilden erfindungsgemäß den zweiten Bereich aus. Demnach durchdringen das erste Gehäuseteil und das zweite Gehäuseteil die Aussparung in der Leiterplatte, wodurch einerseits mindestens zwei Leiter in dem zweiten Bereich durch das erste Gehäuseteil gegen elektrische und/oder elektromagnetische Felder geschirmt sind, und andererseits das erste Gehäuseteil durch das zweite Gehäuseteil galvanisch getrennt von der Leiterplatte gehalten ist. Insbesondere ist es dabei vorteilhaft, wenn das zweite Gehäuseteil das erste Gehäuseteil in dem zweiten Bereich quer zur Steckrichtung vollständig umschließt. Dabei ist weiterhin vorteilhaft, wenn das zweite Gehäuseteil formschlüssig an dem ersten Gehäuseteil gehalten wird, wodurch sich neben den zuvor erläuterten Vorteilen auch eine besonders einfache Montage des erfindungsgemäßen Kantenrand-Steckverbinders ergibt.

Erfindungsgemäß ist vorgesehen, dass die Ausnehmung in dem ersten Gehäuseteil in Steckrichtung für den mindestens einen Leiter jeweils eine Durchbohrung aufweist, durch die der jeweilige zweite Schenkel des jeweiligen mindestens einen Leiters geführt ist, und dass in der jeweiligen Durchbohrung der jeweilige mindestens eine Leiter mittels eines Dielektrikums an dem ersten Gehäuseteil gelagert gehalten wird. Dabei ist es nach Maßgabe dieser Erfindung besonders vorteilhaft, wenn ausschließlich der jeweilige mindestens eine Leiter in der Durchbohrung an dem Gehäuse bzw. dem ersten Gehäuseteil gehalten ist.

Um das zweite Ende des jeweiligen mindestens einen Leiters ist nach Art eines Koaxialsteckverbinders ein Außenleiter angeordnet. Der Außenleiter umgibt den jeweiligen mindestens einen Leiter hülsenförmig, wobei der jeweilige mindestens eine Leiter koaxial zu dem Außenleiter in der Steckrichtung in dem Au-ßenleiter durch ein Dielektrikum von diesem elektrisch isoliert gehalten ist.

Der hülsenförmige Außenleiter ist vorteilhaft elektrisch mit dem ersten Gehäuseteil verbunden. Durch das erste Gehäuseteil kann der mindestens Außenleiter des mindestens einen Leiters gemeinsam mit einer Erdung verbunden werden, wodurch eine besonders einfache Bauweise des erfindungsgemäßen Kantenrand-Steckverbinders realisiert ist.

Mindestens ein Außenleiter ist weiterhin erfindungsgemäß bereichsweise zwischen der ersten Ebene und der zweiten

Ebene angeordnet ist. Bevorzugt befindet sich ein möglichst großer Anteil des mindestens einen Außenleiters auf der der zweiten Ebene zugewandten Seite der ersten Ebene. Gemäß einer erfindungsgemäßen Ausgestaltung beträgt der Anteil des wenigstens einen Außenleiters auf der der zweiten Ebene zugewandten Seite der ersten Ebene ca. 50 %, sodass in dieser spezifischen und bevorzugten Ausgestaltung der mindestens eine Leiter des dazugehörigen Außenleiters annähernd in der ersten Ebene angeordnet ist. Dadurch ist die Bauweise der erfindungsgemäßen Leiterplattenanordnung mit wenigstens einem erfindungsgemäßen Kantenrand-Steckverbinder besonders kompakt.

Eine weitere vorteilhafte Ausgestaltung der vorliegenden Erfindung sieht vor, dass das zweite Gehäuseteil senkrecht zur Steckrichtung wenigstens eine in der ersten Ebene abstehende Schulter aufweist, die bevorzugt eingerichtet ist, auf der Oberseite und/oder der Unterseite der Leiterplatte aufzuliegen. Die Schulter stützt das Gehäuse des Kantenrand-Steckverbinders an der Leiterplatte ab und schützt somit die elektrischen Verbindungen zwischen den Leitern und den Leiterbahnen der Leiterplatte vor mechanischen Einwirkungen beim Stecken und Lösen der Steckverbindung. Die elektrischen Verbindungen zwischen den Leitern und den Leiterbahnen sind typischerweise als Lötverbindungen gebildet.

Eine weitere vorteilhafte Ausgestaltung der vorliegenden Erfindung sieht vor, dass der erste Schenkel des mindestens einen Leiters frei in der Ausnehmung des ersten Gehäuseteils steht. Besonders bevorzugt ist die Ausnehmung derart ausgebildet, dass der mindestens eine Leiter jeweils in Steckrichtung in die Ausnehmung eingesetzt werden kann, wobei der zweite Schenkel des jeweiligen mindestens einen Leiters durch die Durchbohrung geführt werden und anschließend dort mittels des Dielektrikums und des hülsenförmigen Außenleiters befestigt werden kann. Insbesondere hat es sich dabei als vorteilhaft erwiesen, wenn ein drittes Gehäuseteil vorgesehen ist, welches die Ausnehmung des ersten Gehäuseteils verschließt. Weiter ist bevorzugt, wenn das dritte Gehäuseteil aus einem elektrisch leitfähigen Werkstoff hergestellt ist, wodurch die Ausnehmung des ersten Gehäuseteils gegen elektrische und/oder elektromagnetische Felder abgeschirmt ist.

Ein weiterer Aspekt der vorliegenden Erfindung betrifft eine Leiterplattenanordnung mit wenigstens einem erfindungsgemäßen Kantenrand-Steckverbinder, insbesondere einen Kantenrand-Mehrfach-Steckverbinder. Nach Maßgabe der vorliegenden Erfindung ist dabei vorgesehen, dass die Leiterplatte eine in einen Kantenrand eingebrachte Aussparung umfasst, und dass der erste Bereich des Gehäuses des Kantenrand-Steckverbinders in der ersten Ebene auf der Leiterplatte angeordnet ist, und dass der zweite Bereich des Gehäuses in die Aussparung hineinragt.

Nach Maßgabe einer weiteren bevorzugten Ausgestaltung der vorliegenden Erfindung ist dabei vorgesehen, dass die Schultern des zweiten Gehäuseteils in Steckrichtung benachbart zu der Aussparung in der ersten Ebene auf der Leiterplatte aufliegen, wodurch das Gehäuse des Steckverbinders elektrisch isoliert auf der Leiterplatte abgestützt wird.

Nachfolgend wird unter Bezugnahme auf die begleitenden Zeichnung beispielhaft ein erfindungsgemäßes Ausführungsbeispiele der vorliegenden Erfindung beschrieben. Es zeigen:
- Figur 1: eine vereinfachte perspektivische Darstellung einer erfindungsgemäßen Leiterplattenanordnung mit einem Kantenrand-Steckverbinder aufweisend vier Leiter, und
- Figur 2: eine vereinfachte teilweise geschnittene Darstellung der Leiterplattenanordnung gemäß Figur 1.

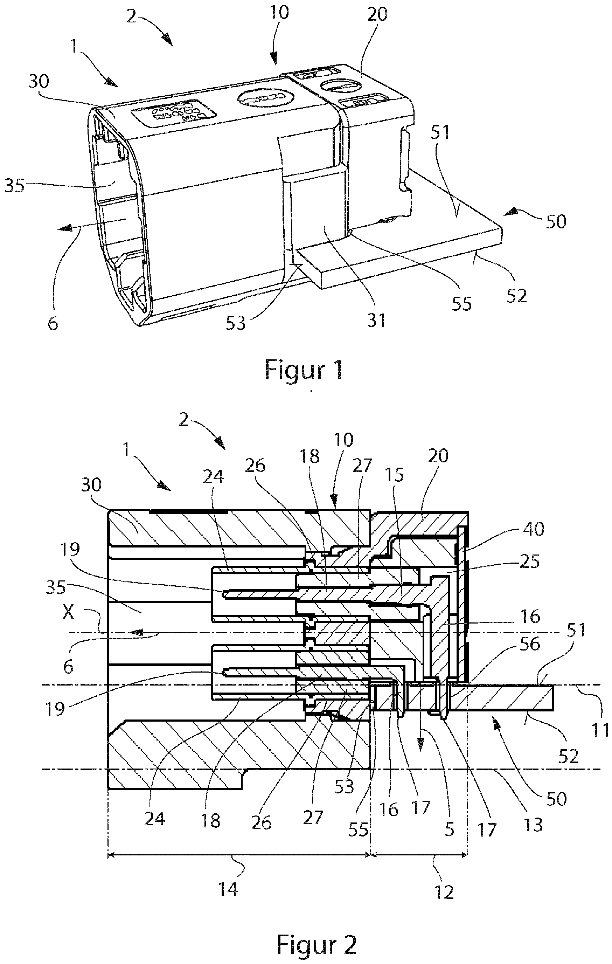

Figur 1 zeigt eine Leiterplattenanordnung 2 umfassend eine Leiterplatte 50 und einen Kantenrand-Steckverbinder 1, der als Kantenrand-Mehrfach-Steckverbinder 1 ausgebildet ist. In den Figuren wird aus Gründen der Vereinfachung die Leiterplatte 50 nur ausschnittsweise dargestellt, wobei die Leiterplatte 50 eine Oberseite 51, eine Unterseite 52 und einen Kantenrand 53, der die Oberseite 51 mit der Unterseite 52 verbindet und sich um den gesamten Umfang der Leiterplatte 50 erstreckt.

Die Leiterplatte 50 ist aus einem elektrisch nicht leitfähigen Werkstoff hergestellt und kann auf der Unterseite 52 eine Vielzahl von Leiterbahnen 54 aufweisen, welche eingerichtet sein können, elektrische Verbindungen mit (nicht dargestellten) elektrischen Bauteilen, welche beispielsweise auf der Oberseite 51 der Leiterplatte 50 angeordnet sein können, zu verbinden.

Zum Herstellen einer elektrischen Verbindung der Leiterbahnen 54, insbesondere zum Herstellen einer elektrischen Verbindung mit zu der Leiterplatte 50 beabstandet angeordneten elektrischen Bauteilen, z.B. Sensoren oder Antennen, ist auf der Oberseite 51 der Leiterplatte 50 im Bereich des Kantenrands 53 der Kantenrand-Steckverbinder 1 angeordnet, in den ein (nicht dargestellter) Gegensteckverbinder in eine Steckrichtung 6 eingesteckt werden kann. Die Steckrichtung 6 ist parallel zu der Oberseite 51 der Leiterplatte 50 und einer Längsachse X ausgerichtet und ist in den Figuren 1 und 2 mittels eines Pfeils kenntlich gemacht. Die Steckrichtung 6 entspricht der Relativbewegung des Kantenrad-Steckverbinders 1 beim Einstecken des Gegensteckverbinders in eine Gegensteckerausnehmung 35.

Im Bereich des Kantenrand-Steckverbinders 1 ist eine Aussparung 55 in die Leiterplatte 50 gesägt, eingearbeitet oder eingeformt, in die der Kantenrand-Steckverbinder 1 - wie nachfolgend noch im Detail erläutert wird - bereichsweise hineinragt, um eine möglichst kompakte Bauform der Leiterplattenanordnung 2 zu bewerkstelligen. Die Aussparung 55 ragt dabei in einer annähernd rechteckigen Form bzw. U-förmig in Steckrichtung 6 von dem Kantenrand 53 in die Leiterplatte 50.

Der Kantenrand-Steckverbinder 1 umfasst, wie insbesondere der Figur 2 zu entnehmen ist, ein zweiteiliges Gehäuse 10 mit einem ersten Gehäuseteil 20 und einem zweiten Gehäuseteil 30. Das Gehäuse 10 weist eine Unterseite, eine Oberseite, eine Rückseite, eine Anschlussseite sowie zwei Stirnseiten auf.

Das erste Gehäuseteil 20 ist aus einem elektrisch leitfähigen Werkstoff, insbesondere einem Metall, hergestellt, während dessen das zweite Gehäuseteil 30 aus einem elektrisch isolierenden Werkstoff, insbesondere Kunststoff, hergestellt ist. Das zweite Gehäuseteil 30 weist auf der Anschlussseite zugewandten Seite in der Steckrichtung 6 eine Durchgangsöffnung auf, die als eine Gegensteckerausnehmung 35 zur Aufnahme eines (nicht dargestellten) Gegensteckverbinders ausgebildet ist und, wie der perspektivischen Darstellung in Figur 1 zu entnehmen ist, ausgebildet ist, eine Lageorientierung des Gegensteckverbinders vorzugeben.

Das Gehäuse 10 bzw. die Unterseite des Gehäuses 10 kann in einen ersten Bereich 12 und einen zweiten Bereich 14 unterteilt werden, wobei in dem ersten Bereich die Unterseite des Gehäuses 10 in der ersten Ebene 11 ausgebildet ist und auf der Oberseite 51 der Leiterplatte 50 aufliegt. In dem zweiten Bereich 14 ist die Unterseite des Gehäuses 10 in eine Montagerichtung 5 beabstandet zu dem ersten Bereich 12 in der zweiten Ebene 13 angeordnet und durchdringt die Aussparung 55 und steht auf der Unterseite 52 der Leiterplatte 50 heraus. Die Montagerichtung 5 ist senkrecht zu der Leiterplatte 50 bzw. deren Oberseite 51 ausgerichtet, wobei die Richtung von der Oberseite 51 zu der Unterseite 52 zeigt.

In dem zweiten Bereich 14 ist das Gehäuse 10 im Wesentlichen in einer Längsachse parallel zu der Steckrichtung 6 symmetrisch ausgebildet und das zweite Gehäuseteil 30 umgibt das erste Gehäuseteil 20.

Der Kantenrand-Mehrfach-Steckverbinder 1 umfasst mindestens einen Leiter 15. Der mindestens eine Leiter 15 ist ausgebildet, elektrische Signale, insbesondere hochfrequente elektrische Signale von entsprechenden (nicht dargestellten) Kontakten eines Gegensteckverbinders zu der jeweiligen entsprechenden Leiterbahn 54 der Leiterplatte 50 zu übertragen. Im dargestellten Ausführungsbeispiel umfasst der Kantenrand-Mehrfach-Steckverbinder 1 vier Leiter 15, welche jeweils zueinander parallel und beabstandet in zwei Reihen, nämlich einer ersten Reihe und einer zweiten Reihe, angeordnet sind. Alternative Ausgestaltungen eines erfindungsgemäßen Kantenrand-Steckverbinders umfassen einen, zwei, drei, vier, fünf, sechs und mehr Leiter 15, wobei bevorzugt der Kantenrand-Mehrfach-Steckverbinder eine gerade Anzahl von Leitern 15 umfasst.

Der jeweilige Leiter 15 umfasst einen ersten Schenkel 16 und einen zweiten Schenkel 18, wobei der erste Schenkel 16 ein erstes Ende 17 und der zweite Schenkel 18 ein zweites Ende 19 des jeweiligen Leiters 15 aufweist. Die Leiter 15 sind im dargestellten Ausführungsbeispiel L-förmig ausgebildet, so dass der erste Schenkel 16 senkrecht zu dem zweiten Schenkel 18 ausgerichtet ist.

Der erste Schenkel 16 ist, wie Figur 2 zu entnehmen ist, senkrecht zu der Oberseite 51 der Leiterplatte 50 ausgerichtet und das erste Ende 17 des Leiters 15 steht in einer Montagerichtung 5 aus dem ersten Gehäuseteil 20 heraus. Das jeweils frei abstehende erste Ende 17 des Leiters 15 durchdringt im montierten Zustand des Kantenrand-Steckverbinders 1 auf der Leiterplatte 50 jeweils eine Durchgangsbohrung 56 in der Leiterplatte 50, um eine elektrische Verbindung mit den auf der Unterseite 52 angeordneten Leiterbahnen 54 herzustellen. Die Ausrichtung der Durchgangsbohrungen 56 in der Leiterplatte 50 gibt die Montagerichtung 5 vor, in welche die freien ersten Enden 17 der Leiter 15 in die Leiterplatte zu Montagezwecken eingeführt werden müssen.

Das erste Gehäuseteil 20 umfasst eine Ausnehmung 25, die die Leiter 15 aufnimmt und in der die Leiter 15 elektrisch isoliert gehalten sind. Die Ausnehmung ist 25 von der Rückseite des Gehäuses 10 in Steckrichtung 6 in das erste Gehäuseteil 20 eingeformt oder eingearbeitet und wird nach der Montage des Kantenrand-Steckverbinders 1 mit einem dritten Gehäuseteil 40 verschlossen.

Darüber hinaus umfasst das erste Gehäuseteil 20 für jeden Leiter 15 eine Durchbohrung 26, die zueinander beabstandet und parallel zu der Längsachse X das erste Gehäuseteil 20 durchdringen. In der jeweiligen Durchbohrung 26 ist der zweite Schenkel 18 des jeweiligen Leiters 50 mittels eines Dielektrikums 27 gelagert gehalten, wobei zwischen der Außenwandung der Durchbohrung 26 und dem Dielektrikum 27 ein hülsenförmiger Außenleiter 24 angeordnet ist, der koaxial zu dem zweiten Schenkel 18 ausgerichtet ist und zusammen mit dem zweiten Ende 19 des Leiters 15 in Steckrichtung 6 in die Gegensteckerausnehmung 35 des zweiten Gehäuseteils 30 ragt.

Die Leiter 15 bzw. deren zweite Schenkel 18, sind in der ersten Reihe und der zweiten Reihe parallel zueinander beabstandet und parallel zu der Oberseite 51 der Leiterplatte 50 angeordnet. Die erste Reihe ist dabei unmittelbar benachbart zu der Oberseite 51 bzw. der ersten Ebene 11 angeordnet.

Um eine möglichst geringe Bauhöhe der Leiterplattenanordnung 2 zusammen mit dem Kantenrand-Steckverbinder 1 zu erreichen, ist wie Figur 2 zeigt, der Leiter 15 in der ersten Reihe möglichst in der ersten Ebene 11 angeordnet. Um den erforderlichen minimalen Abstand zwischen dem zweiten Schenkel 18 und der Leiterplatte 50 einzuhalten, liegt dieser zweite Schenkel 18 des Leiters 15 auf der ersten Ebene 11 und ragt in Steckrichtung 6 in die Gegensteckerausnehmung 35 des zweiten Gehäuseteils 30. Der diesem Leiter 15 zugeordnete hülsenförmige Außenleiter 24 ragt bereichsweise in die Aussparung 55 und schneidet die erste Ebene 11, wobei besonders bevorzugt ein besonders großer Anteil des einen hülsenförmigen Außenleiters 24 zwischen der ersten Ebene 11 und der zweiten Ebene 13 angeordnet ist.

Die hülsenförmigen Außenleiter 24 sind elektrisch mit dem ersten Gehäuseteil 20 verbunden und stecken hierzu fest in der Durchbohrung 26 des ersten Gehäuseteils 20. Dementsprechend bildet das zweite Gehäuseteil 30, welches aus einem elektrisch leitfähigen Werkstoff hergestellt ist, ebenfalls einen Teil des Außenleiters, und kann durch entsprechende Vorkehrungen ebenfalls mit einer Leiterbahn 55 auf der Unterseite 52 der Leiterplatte verbunden werden.

Um bestmögliche elektrische Kontakte zwischen dem nicht dargestellten Gegensteckverbinder und den Leitern 15 und den hülsenförmigen Außenleitern 24 zu bewerkstelligen, können die Leiter 15 und/oder die Außenleiter 24 aus einem Edelmetall, insbesondere Silber oder Gold hergestellt sein, oder eine Beschichtung mit einem solchen Edelmetall aufweisen. Weiterhin ist es von Vorteil, wenn in Steckrichtung 6 der hülsenförmige Außenleiter 24 den jeweiligen Leiter 15 überragt.

Die Gegensteckerausnehmung 35 kann ausgebildet sein, eine Zentrierung des Gegensteckverbinders beim Überführen in den gesteckten Zustand vorzunehmen, wodurch ein Winkelversatz zwischen den Kontakten des Gegensteckverbinders und dem zweiten Ende der jeweiligen Leiter 15 und der Außenleiter 24 vermieden wird.

Somit werden erfindungsgemäß ein Kantenrand-Steckverbinder 1 sowie eine Leiterplattenanordnung 2 zur Verfügung gestellt, die das simultane Verbinden einer Mehrzahl von Leitern 15 mit einem entsprechenden Gegensteckverbinder ermöglichen, und dabei eine möglichst geringe Bauhöhe aufweisen, wodurch der für eine Leiterplattenanordnung 2 verfügbare Bauraum möglichst effizient ausgenutzt wird. Weiterhin ist die Entstehung von passiven Intermodulationen in dem Kantenrand -Steckverbinder 1 durch die Vermeidung von Metall-zu-Metallkontakten auf das Geringste reduziert und eine bestmögliche Schirmung der Leiter 15 gegen elektrische- und/oder elektromagnetische Felder ist gewährleistet.

### Bezugszeichenliste

- 1: Steckverbinder
- 2: Leiterplattenanordnung
- 5: Montagerichtung
- 6: Steckrichtung
- 10: Gehäuse
- 11: erste Ebene
- 12: erster Bereich
- 13: zweite Ebene
- 14: zweiter Bereich
- 15: Leiter
- 16: erster Schenkel
- 17: erstes Ende
- 18: zweiter Schenkel
- 19: zweites Ende
- 20: erstes Gehäuseteil
- 24: Außenleiter
- 25: Ausnehmung
- 26: Durchbohrung
- 27: Dielektrikum
- 30: zweites Gehäuseteil
- 31: Schulter
- 35: Gegensteckerausnehmung
- 40: drittes Gehäuseteil
- 50: Leiterplatte
- 51: Oberseite
- 52: Unterseite
- 53: Kantenrand
- 54: Leiterbahn
- 55: Aussparung

## Patentansprüche

1. Kantenrand-Steckverbinder (1) für eine Leiterplatte (50) umfassend:
- ein wenigstens zweiteiliges Gehäuse (10) mit einem ersten Gehäuseteil (20) und einem zweiten Gehäuseteil (30),
- wobei das erste Gehäuseteil (20) aus einem elektrisch leitfähigen Werkstoff hergestellt ist und eine Ausnehmung (25) aufweist, in der mindestens ein Leiter (15) angeordnet ist, und das erste Gehäuseteil (20) mit dem zweiten Gehäuseteil (30) fest verbunden ist, und dass das zweite Gehäuseteil (30) aus einem nicht elektrisch leitfähigen Werkstoff, insbesondere Kunststoff, hergestellt ist,
- wobei der mindestens eine Leiter (15) einen ersten Schenkel (16) mit einem ersten Ende (17) und einen zweiten Schenkel (18) mit einem zweiten Ende (19) aufweist,
- wobei das Gehäuse (10) einen ersten Bereich (12) in einer ersten Ebene (11) umfasst, in den das jeweilige erste Ende (17) in einer Montagerichtung (5) aus dem Gehäuse (10) zur Verbindung mit einer Leiterbahn (54) der Leiterplatte (50) ragt,
- wobei das Gehäuse (10) einen zweiten Bereich (14) in einer zweiten Ebene (13) umfasst, die in der Montagerichtung (5) parallel und beabstandet zu der ersten Ebene (11) angeordnet ist,
- wobei der zweite Schenkel (18) in einem Winkel von 90° zu dem ersten Schenkel (16) angeordnet ist, und der zweite Schenkel (18) in eine Gegensteckerausnehmung (35) in dem zweiten Gehäuseteil (30) in eine Steckrichtung (6) ragt,
- wobei die Ausnehmung (25) in dem ersten Gehäuseteil (20) in Steckrichtung (6) für jeden Leiter (15) jeweils eine Durchbohrung (26) aufweist, durch die der jeweilige zweite Schenkel (18) des Leiters (15) geführt ist, und dass im Bereich der jeweiligen Durchbohrung (26) der jeweilige Leiter mit einem Dielektrikum (27) an dem ersten Gehäuseteil (20) abgestützt ist,
- wobei das zweite Ende (19) des jeweiligen Leiters (15) als koaxialer Steckverbinder ausgebildet ist, und dass um das zweite Ende (19) des jeweiligen Leiters (15) ein hülsenförmiger Außenleiter (24) ausgebildet ist, der zwischen einer Außenwandung der Durchbohrung (26) und dem Dielektrikum (27) angeordnet und koaxial zu dem zweiten Schenkel (18) ausgerichtet ist und zusammen mit dem zweiten Ende (19) des Leiters (15) in Steckrichtung in die Gegensteckerausnehmung des zweiten Gehäuseteils ragt,
**dadurch gekennzeichnet, dass**
- der erste Gehäuseteil (20) und der zweite Gehäuseteil (30) den zweiten Bereich (14) ausbilden,
- wobei wenigstens ein Außenleiter (24) bereichsweise zwischen der ersten Ebene (11) und der zweiten Ebene (13) angeordnet ist.

2. Kantenrand-Steckverbinder (1) nach Anspruch 1,
**dadurch gekennzeichnet, dass**
der Kantenrand-Steckverbinder (1) als Kantenrand-Mehrfach-Steckverbinder (1) ausgebildet ist und mindestens zwei Leiter (15) aufweist, die beabstandet zueinander angeordnet sind.

3. Kantenrand-Steckverbinder (1) nach Anspruch 2,
**dadurch gekennzeichnet, dass**
die mindestens zwei Leiter (15) in mindestens zwei Reihen parallel zu der ersten Ebene (11) angeordnet sind.

4. Kantenrand-Steckverbinder (1) nach einem der vorgenannten Ansprüche,
**dadurch gekennzeichnet, dass**
das zweite Gehäuseteil (30) das erste Gehäuseteil (20) im zweiten Bereich (14) quer zur Steckrichtung (6) umschließt.

5. Kantenrand-Steckverbinder (1) nach einem der vorgenannten Ansprüche,
**dadurch gekennzeichnet, dass**
der hülsenförmige Außenleiter (24) elektrisch mit dem Gehäuse (10) verbunden ist.

6. Kantenrand-Steckverbinder (1) nach einem der vorgenannten Ansprüche,
**dadurch gekennzeichnet, dass**
das zweite Gehäuseteil (30) senkrecht zur Steckrichtung (6) in der ersten Ebene (11) abstehende Schultern (31) umfasst, die eingerichtet sind, auf der Leiterplatte (50) aufzuliegen.

7. Kantenrand-Steckverbinder (1), nach einem der vorgenannten Ansprüche,
**dadurch gekennzeichnet, dass**
das erste Gehäuseteil (20) und das zweite Gehäuseteil (30) formschlüssig mit einander verbunden sind.

8. Kantenrand-Steckverbinder (1), nach einem der vorgenannten Ansprüche,
**dadurch gekennzeichnet, dass**
der erste Schenkel (16) des jeweiligen Leiters (15) frei in der Ausnehmung (25) des ersten Gehäuseteils (20) steht.

9. Kantenrand-Steckverbinder (1) nach einem der vorgenannten Ansprüche,
**dadurch gekennzeichnet, dass**
ein drittes Gehäuseteil (40) vorgesehen ist, welches die Ausnehmung (25) des zweiten Gehäuseteils (20) verschließt.

10. Leiterplattenanordnung (2) mit wenigstens einem Kantenrand-Steckverbinder (1) gemäß einem der vorgenannten Ansprüche,
**dadurch gekennzeichnet, dass**
die Leiterplatte (50) eine Aussparung (55) umfasst, dass der erste Bereich (12) des Gehäuses auf der Leiterplatte (50) angeordnet ist, und dass der zweite Bereich (14) des Gehäuses (10) in die Aussparung (55) hineinragt.

11. Leiterplattenanordnung (2) nach Anspruch 10,
**dadurch gekennzeichnet, dass**
die Schultern (31) in Steckrichtung (6) benachbart zu der Aussparung (55) in der ersten Ebene (11) auf der Leiterplatte (50) aufliegen.

## Claims

1. Board edge plug connector (1) for a printed circuit board (50), comprising:
- an at least two-piece housing (10), with a first housing part (20) and a second housing part (30),
- wherein the first housing part (20) is made of an electrically conductive material and comprises a recess (25) in which at least one conductor (15) is arranged, and in that the first housing part (20) is rigidly connected to the second housing part (30), and in that the second housing part (30) is made of an electrically nonconductive material, in particular of plastic,
- wherein the at least one conductor (15) comprises a first limb (16) with a first end (17) and a second limb (18) with a second end (19),
- wherein the housing (10) comprises a first region (12) in a first plane (11), into which the respective first end (17) extends in a mounting direction (5) from out of housing (10) in order to be connected to a conductor track (54) of the printed circuit board (50),
- wherein the housing (10) comprises a second region (14) in a second plane (13), which is arranged in the mounting direction (5) parallel and at a distance to the first plane (11),
- wherein the second limb (18) is arranged at an angle of 90° to the first limb (16), and the second limb (18) extends, in a plug-in direction, into a mating connector recess (35) in the second housing part (30),
- wherein the recess (25) in the first housing part (20) comprises, in the plug-in direction (6), a respective through bore (26) for each of the conductors (15), through which the respective second limb (18) of the conductor (15) is inserted, and in that, in the region of the respective through bore (26), the dielectric (27) of the respective conductor rests against the first housing part (20),
- wherein the second end (19) of the respective conductor (15) is implemented as a coaxial plug connector, and in that a sleeve-shaped outer conductor (24) is implemented around the second end (19) of the respective conductor (15), which is arranged between an outer wall of the through bore (26) and the dielectric (27) and is aligned coaxially to the second limb (18) and which, together with the second end (19) of the conductor (15) extends, in the plug-in direction, into the mating connector recess (35) of the second housing part (30),
**characterized in that**
- the first housing part (20) and the second housing part (30) form the second region (14),
- wherein at least one outer conductor (24) is partially arranged between the first plane (11) and the second plane (13).

2. Board edge plug connector (1) in accordance with claim 1,
**characterized in that**
the board edge plug connector (1) is implemented as a board edge multiple plug connector (1) and comprises at least two conductors (15) which are arranged at a distance to each other.

3. Board edge plug connector (1) in accordance with claim 2,
**characterized in that** the at least two conductors (15) are arranged in at least two rows, parallel to the first plane (11).

4. Board edge plug connector (1) in accordance with any of the preceding claims,
**characterized in that**
the second housing part (30) encloses the first housing part (20) in the second region (14), perpendicular to the plug-in direction (6).

5. Board edge plug connector (1) in accordance with any of the preceding claims,
**characterized in that**
the sleeve-shaped outer conductor (24) is electrically connected to the housing (10).

6. Board edge plug connector (1) in accordance with any of the preceding claims,
**characterized in that**
the second housing part (30) comprises, vertically to the plug-in direction (6) in the first plane (11), projecting shoulders (31) which are configured to rest on the printed circuit board (50).

7. Board edge plug connector (1) in accordance with any of the preceding claims, **characterized in that** the first housing part (20) and the second housing part (30) are positively connected to each other.

8. Board edge plug connector (1) in accordance with any of the preceding claims,
**characterized in that**
the first limb (16) of the respective conductor (15) stands freely in the recess (25) of the first housing part (20).

9. Board edge plug connector (1) in accordance with any of the preceding claims,
**characterized in that**
a third housing part (40) is provided which closes the recess (25) of the second housing part (20).

10. Printed circuit board arrangement (2) having at least one board edge plug connector (1) in accordance with any of the preceding claims,
**characterized in that**
the printed circuit board (50) comprises a cutout (55), **in that** the first region (12) of the housing is arranged on the printed circuit board (50), and **in that** the second region (14) of the housing (10) extends into the cutout (55).

11. Printed circuit board arrangement (2) in accordance with claim 10,
**characterized in that**
the shoulders (11) rest in the plug-in direction (6) adjacent to the cutout (55) in the first plane (11) on the printed circuit board (50).

## Revendications

1. Connecteur de bord, enfichable (1), pour une carte de circuit imprimé (50) comprenant :
- au moins un boîtier (10) en deux parties, a une première partie de boîtier (20) et une seconde partie de boîtier (30),
- la première partie de boîtier (20) en une matière électro-conductrice ayant une cavité (25) recevant au moins un conducteur (15) et la première partie du boîtier (20) est reliée solidairement à la seconde partie du boîtier (30), et
- la seconde partie du boîtier (30) est en une matière non électro-conductrice notamment en matière plastique,
- ce conducteur (15) a une première branche (16) avec une première extrémité (17) et une seconde branche (18) avec une seconde extrémité (19),
- le boîtier (10) comprend une première zone (12) dans un premier plan (11) dans lequel la première extrémité respective (17) vient en saillie dans une direction de montage (5) par rapport au boîtier (10) pour le branchement à un chemin conducteur (54) de la carte de circuit imprimé (50),
- le boîtier (10) a une seconde zone (14) dans un second plan (13) parallèle et écarté dans la direction de montage (5) par rapport au premier plan (11),
- la seconde branche (18) faisant un angle de 90° par rapport à la première branche (16) et la seconde branche (18) venant en saillie dans un évidement de connecteur complémentaire (35) dans la seconde partie de boîtier (30) dans la direction d'enfichage (6),
- la cavité (25) dans la première partie de boîtier (20) ayant un perçage traversant (26) respectif pour chaque conducteur (15) à travers lequel passe la seconde branche (18) du conducteur (15) et dans la zone du perçage traversant (26) respectif, le conducteur correspondant s'appuie par un diélectrique (27) contre la première partie de boîtier (20),
- la seconde extrémité (19) du conducteur (15) respectif est sous la forme d'un connecteur coaxial et un conducteur extérieur en forme de manchon (24) est réalisé autour de la seconde extrémité (19) du conducteur (15) respectif, ce conducteur extérieur étant prévu entre une paroi extérieure du perçage traversant (26) et le diélectrique (27) et il est orienté coaxialement à la seconde branche (18) et vient en saillie avec la seconde extrémité (19) du conducteur (15) dans la direction d'enfichage, dans la cavité de connecteur complémentaire de la seconde partie de boîtier,
connecteur **caractérisé en ce que**
la première partie de boîtier (20) et la seconde partie de boîtier (30) forment la seconde zone (14),
- au moins un conducteur extérieur (24) étant prévu par zone entre le premier plan (11) et le second plan (13).

2. Connecteur de bord enfichable (1) selon la revendication 1,
**caractérisé en ce que**
le connecteur de bord enfichable (1) est réalisé comme connecteur enfichable, multiple, de bord (1) et il comporte au moins deux conducteurs (15) écartés l'un de l'autre.

3. Connecteur de bord enfichable (1) selon la revendication 2,
**caractérisé en ce que**
au moins les deux conducteurs (15) sont situés dans au moins deux rangées parallèles au premier plan (11).

4. Connecteur de bord enfichable (1) selon l'une des revendications précédentes,
**caractérisé en ce que**
la seconde partie de boîtier (30) entoure la seconde zone (14) de la première partie de boîtier (20) transversalement à la direction d'enfichage (6).

5. Connecteur de bord enfichable (1) selon l'une des revendications précédentes,
**caractérisé en ce que**
le conducteur extérieur (24) en forme de manchon est relié électriquement au boîtier (10).

6. Connecteur de bord enfichable (1) selon l'une des revendications précédentes,
**caractérisé en ce que**
la seconde partie de boîtier (30) comprend des épaulements (31) en saillie perpendiculairement à la direction d'enfichage (6) dans le premier plan (11) et qui s'appuient sur la carte de circuit imprimé (50).

7. Connecteur de bord enfichable (1) selon l'une des revendications précédentes,
**caractérisé en ce que**
la première partie de boîtier (20) et la seconde partie de boîtier (30) sont reliées l'une à l'autre par une liaison par la forme.

8. Connecteur de bord enfichable (1) selon l'une des revendications précédentes,
**caractérisé en ce que**
la première branche (16) du conducteur (15) respectif est libre dans la cavité (25) de la première partie de boîtier (20).

9. Connecteur de bord enfichable (1) selon l'une des revendications précédentes,
**caractérisé en ce qu'**il comprend :
une troisième partie de boîtier (40) qui ferme la cavité (25) de la seconde partie de boîtier (20).

10. Dispositif de carte de circuit imprimé (2) comprenant au moins un connecteur de bord enfichable (1) selon l'une des revendications précédentes,
**caractérisé en ce que**
la carte de circuit imprimé (50) a un évidement (55),
la première zone (12) du boîtier est installée sur la carte de circuit imprimé (50), et
la seconde zone (14) du boîtier (10) vient dans l'évidement (55).

11. Dispositif de carte de circuit imprimé (2) selon la revendication 10,
**caractérisé en ce que**
les épaulements (31) s'appuient sur la carte de circuit imprimé (50) dans la direction d'enfichage (6) au voisinage de l'évidement (55) dans le premier plan (11).
